Europäisches Patentamt

European Patent Office

Office européen des brevets

(11) Veröffentlichungsnummer: **0 257 428**
**A1**

# (12) EUROPÄISCHE PATENTANMELDUNG

(21) Anmeldenummer: 87111570.5

(22) Anmeldetag: **10.08.87**

(51) Int. Cl.4: **H01F 15/10** , **H01F 41/10**

(30) Priorität: **11.08.86 DE 3627210**

(43) Veröffentlichungstag der Anmeldung:
**02.03.88 Patentblatt 88/09**

(84) Benannte Vertragsstaaten:
**DE FR GB IT NL**

(71) Anmelder: **Siemens Aktiengesellschaft Berlin und München**
**Wittelsbacherplatz 2**
**D-8000 München 2(DE)**

(72) Erfinder: **Ehrgott, Roland**
**Quiddestrasse 68**
**D-8000 München 83(DE)**

(54) Elektrischer Anschlussstift für oberflächenmontierbare elektrische Spulen.

(57) Elektrischer Anschlußstift (6) für oberflächenmontierbare elektrische Spulen, der mit seinem einen Teil in einen Spulenkörper (3, 4) eingelassen und mit seinem freien Ende auf eine Schaltungsplatine aufsetz = und auf diese auflötbar ist. Der Anschlußstift (6) ist dabei jeweils mit flachen Stirnenden, insbesonder Flanschen (8, 8) und achssymmetrisch ausgebildet.

## FIG 2

EP 0 257 428 A1

## Elektrischer Anschlußstift für oberflächenmontierbare elektrische Spulen

Die Erfindung betrifft einen elektrischen Anschlußstift für oberflächenmontierbare elektrische Spulen, der mit seinem einen Teil in einen Spulenkörper eingelassen und mit seinem freien Ende auf eine Schaltungsplatine aufsetz = und auf diese auflötbar ist.

Im Zuge der fortschreitenden Automatisierung gewinnt die sogenannte SMD-Technik zunehmend an Bedeutung; d.h. daß in steigendem Maße unbedrahtete Bauelemente auf die Leiterbahnenseite einer Schaltungsplatine aufgebracht und meist durch Schwallöten auf ihr montiert werden. Neuartige Schaltungskonzepte, entsprechende Bestückungsautomaten sowie ein breit gefächertes Typenspektrum an unbedrahteten Bauelementen ermöglichen den Übergang zu dieser neuen Aufbautechnik.

Im Rahmen dieser Entwicklung stellt sich die Frage nach der Oberflächenmontierbarkeit auch für elektrische Spulen, Übertrager, Drosseln und dergleichen, deren Wickeldrähte um Anschlußbeine gewickelt und anschließend z.B. mittels Tauchbzw. Schwallöten auf Schaltungsplatinen befestigt werden.

Aufgabe der vorliegenden Erfindung ist daher die Schaffung bzw. Gestaltung von Anschlußstiften für elektrische Spulen und dergleichen, die hinsichtlich der Oberflächenmontierbarkeit der Bauelemente sämtliche Forderungen erfüllen, insbesondere auch mittels Bestückungsautomaten problemlos verarbeitbar sind.

Zur Lösung dieser Aufgabe sieht die Erfindung bei einem elektrischen Anschlußstift der eingangs genannten Art vor, daß dieser jeweils mit flachen Stirnenden, insbesondere Flanschen und achssymmetrisch ausgebildet ist.

Durch die achssymmetrische Gestaltung des Anschlußstiftes, der vorwiegend aus einer Kupfer-Zinn-Legierung besteht, ist beim Einbetten des Anschlußstiftes in einen Spulenkörper bzw. Spulenkörperflansch eine automatische Zuführung in das hierfür bestimmte Spritzwerkzeug möglich. Es herrschen nämlich aufgrund der Achsensymmetrie stets die gleichen Verhältnisse, gleichgültig ob der Anschlußstift mit seinem einen oder anderen Stirnteil in den Spulenkörper eingebettet wird.

Der Anschlußstift an sich und seine als Flansche gestalteten Stirnenden können dabei kreis- oder polygonalen Querschnitt haben.

Bevorzugt weist der Anschlußtstift in Längsmitte einen zum Anschlußstift konzentrischen ringförmigen Bund auf, der etwa bis zur halben Bundhöhe in den Spulenkörper, insbesondere Spulenkörperflansch, eingespritzt wird.

Das Bewickeln der mit diesen Anschlußstiften ausgerüsteten Bauelemente kann auf handelsüblichen Wickelautomaten geschehen.

Die Oberflächenmontage der mit diesen Anschlußstiften ausgebildeten Bauelemente auf einer Schaltungsplatine erfolgt bevorzugt mittels Bad, Reflow, Kondensations-(Dampfphase) oder Heißgaslöten.

Die Erfindung wird nachstehend anhand eines Ausführungsbeispiels näher erläutert. Es zeigt:

Fig. 1 eine Seitenansicht eines mit Anschlußstiften gemäß der Erfindung ausgestatteten Spulenkörpers,

Fig. 2 einen Ausschnitt A nach Fig. 1 in teils geschnittener Darstellung.

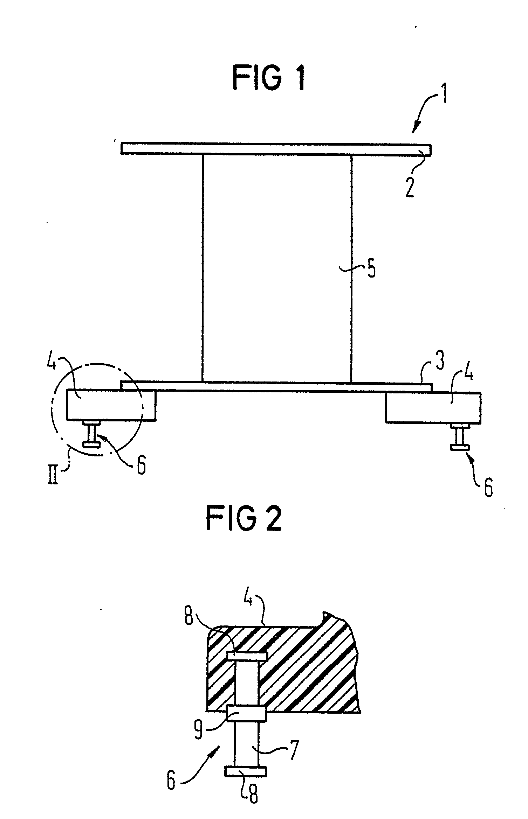

Der Spulenkörper 1 nach Fig. 1 besitzt einen Wickelkörper 2, an dessen Stirnenden angeformte Spulenkörperflansche 2, 3 und an den Spulenkörperflansch 3 angeformte Stege 4, 4 mit gegenüber dem Spulenkörperflansch 3 erhöhter Stärke. In diese Stege sind Anschlußstifte 6, 6 eingelassen bzw. eingespritzt, welche in vergrößertem Maßstab in Fig. 2 gezeigt sind.

Die Anschlußstifte 6 weisen einen Stiftteil 7, einen in Längsmitte dieses Stiftteiles angeformten Bund 9 und an die Stirnenden angeformte flache Stirnenden, insbesondere Flansche 8, 8 auf. Dieser Anschlußstift ist - wie auch aus der Zeichnung ersichtlich ist - achssymmetrisch gestaltet; d.h. bezogen auf eine zur Längsmittelachse des Anschlußstiftes senkrechte Ebene sind die beiden Achshälften spiegelbildlich. Die Zuführung dieser Anschlußstifte zum Spritzwerkzeug erfolgt daher stets in richtiger Weise, gleichgültig mit welchem Ende diese erfolgt.

## Ansprüche

1. Elektrischer Anschußstift für oberflächenmontierbare elektrische Spulen, der mit seinem einen Teil in einen Spulenkörper eingelassen und mit seinem freien Ende auf eine Schaltungsplatine aufsetz - und auf diese auflötbar ist, **dadurch gekennzeichet,** daß der Anschlußstift (6) jeweils mit flachen Stirnenden (8, 8) und achssymmetrisch ausgebildet ist.

2. Elektrischer Anschlußstift nach Anspruch 1, **dadurch gekennzeichnet,** daß der Anschlußstift (6) in Längsmitte einen zum Anschlußstift konzentrischen ringförmigen Bund (9) aufweist.

3. Elektrischer Anschlußstift nach Anspruch 1, **dadurch gekennzeichnet,** daß die Anschlußstiftenden als Flansche (8, 8) gestaltet sind.

4. Elektrischer Anschlußstift nach Anspruch 1, **dadurch gekennzeichnet,** daß der Anschlußstift (6) polygonalen Querschnitt aufweist.

5. Spulenkörper mit einem Anschlußstift nach Anspruch 1 bis 4, **dadurch gekennzeichnet,** daß der Anschlußstift (6) etwa bis zu halben Bundhöhe in den Spulenkörper (1), insbesondere Spulenkörperflansch (3, 4) eingebettet ist.

0 257 428

FIG 1

FIG 2

## EINSCHLÄGIGE DOKUMENTE

| Kategorie | Kennzeichnung des Dokuments mit Angabe, soweit erforderlich der maßgeblichen Teile | Betrifft Anspruch | KLASSIFIKATION DER ANMELDUNG (Int. Cl.4) |
|---|---|---|---|
| X | US-A-3 215 964 (HORBACH) * Spalte 1, Zeilen 55-58; Spalte 2, Zeilen 23-45; Figuren 1-3; Spalte 3, Zeilen 20-35; Figuren 4-7 * --- | 1 | H 01 F 15/10 H 01 F 41/10 |
| A | US-A-3 284 258 (PATTI) * Spalte 3, Zeilen 9-22; Figur 4 * --- | 4 | |
| A | DE-A-2 644 406 (LICENTIA) ----- | | |

RECHERCHIERTE
SACHGEBIETE (Int. Cl.4)

H 01 F
H 01 R
H 05 K

Der vorliegende Recherchenbericht wurde für alle Patentansprüche erstellt

| Recherchenort | Abschlußdatum der Recherche | Prüfer |
|---|---|---|
| DEN HAAG | 16-11-1987 | BIJN E.A. |

KATEGORIE DER GENANNTEN DOKUMENTEN

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angefzhrtes Dokument

& : Mitglied der gleichen Patentfamilie, übereinstimmendes Dokument